# EUROPEAN PATENT APPLICATION

(11) **EP 4 852 312 A1**
(43) Date of publication of application: **09.12.2026**
(21) Application number: 25887958.4
(22) Date of filing: 13.10.2025
(51) Int. Cl.: H02S 40/34

(54) **SOLAR CELL MODULE, PHOTOVOLTAIC DEVICE, ELECTRIC APPARATUS, AND POWER GENERATION APPARATUS**

(30) Priority: 06.11.2024 CN 202422704273 U
(71) Applicant: Contemporary Amperex Technology Co., Limited, Ningde, Fujian 352100 (CN)
(72) Inventor: LIU, Xiao, Ningde, Fujian 352100 (CN); XIE, Qiaowen, Ningde, Fujian 352100 (CN); TU, Bao, Ningde, Fujian 352100 (CN)
(74) Representative: Ran, Handong
(86) International application number: PCT/CN2025/127243
(87) International publication number: WO 2026/098148

(57) **Abstract**

The present application relates to a solar cell module, a photovoltaic device, an electric apparatus, and a power generation apparatus. In the solar cell module, two busbars are used to respectively connect a junction box to a positive electrode end and a negative electrode end of a cell body, so as to realize the electrical connection between the junction box and the cell body. During structural design of the busbars, at least one busbar can be designed to comprise a first busbar portion, an extending portion, and a connecting portion, wherein the extending portion is located outside of one end of the cell body in a second direction. It can be seen therefrom that when electrically connected to the junction box, the extending portion is led outside of one end of the cell body, such that the distribution of the portion of the busbar located between the positive electrode end or the negative electrode end and the junction box on the surface of the cell body is reduced, thus reducing the probability of stress concentration caused by the busbar to the cell body, and improving the stability of the solar cell module.

## Description

### CROSS-REFERENCE TO RELATED APPLICATIONS

The present application claims priority to Chinese Patent Application No. 2024227042736, filed with the China National Intellectual Property Administration on November 6, 2024 and entitled "SOLAR CELL MODULE, PHOTOVOLTAIC DEVICE, POWER CONSUMING APPARATUS, AND POWER GENERATION APPARATUS", which is incorporated herein by reference in its entirety.

### TECHNICAL FIELD

The present application relates to the technical field of solar cells, and in particular to a solar cell module, a photovoltaic device, a power consuming apparatus, and a power generation apparatus.

### BACKGROUND

A solar cell module refers to a device that converts light energy into electric energy by using a photovoltaic effect, and includes a junction box. The junction box is an important part of the solar cell module, and is mainly a core part that communicates an inside and an outside of the module and effectively leads out electric energy. During assembly of the junction box, busbars and insulating tapes are usually arranged in the solar cell module, and the solar cell module is electrically connected to the junction box by using the busbars. However, due to a structural design of the solar cell module, stress concentration easily occurs inside the solar cell module, thereby affecting stability of the module.

### SUMMARY

Based on this, it is necessary to provide a solar cell module, a photovoltaic device, a power consuming apparatus, and a power generation apparatus, so as to reduce probability of stress damage inside the solar cell module and improve stability of the module.

According to a first aspect, the present application provides a solar cell module, and the solar cell module includes: a cell body, including a positive electrode end and a negative electrode end spaced in a first direction; a junction box, located on a side of the cell body in a thickness direction of the cell body; and two busbars, respectively correspondingly connected to the positive electrode end and the negative electrode end, and both electrically connected to the junction box. At least one of the two busbars includes a first busbar portion, an extending portion, and a connecting portion sequentially connected. The first busbar portion is connected to the positive electrode end and/or the negative electrode end. The extending portion is located outside of one end of the cell body in a second direction. The connecting portion is connected to the extending portion and the junction box. The first direction, the second direction, and the thickness direction of the cell body intersect pairwise, and the first direction, the second direction, and the thickness direction of the cell body are not coplanar.

In the above solar cell module, the two busbars are used to respectively connect the junction box to the positive electrode end and the negative electrode end of the cell body, so as to realize electrical connection between the junction box and the cell body. During structural design of the busbars, at least one busbar can be designed to include the first busbar portion, the extending portion, and the connecting portion. The extending portion is located outside of one end of the cell body in the second direction. It can be seen therefrom that when electrically connected to the junction box, the extending portion is led outside of one end of the cell body, such that a distribution of a part of the busbar located between the positive electrode end or the negative electrode end and the junction box on a surface of the cell body is reduced, thus reducing probability of stress concentration caused by the busbar to the cell body, and improving stability of the solar cell module.

In some embodiments, the extending portion extends in the first direction, and a projection of one end of the extending portion connected to the connecting portion in the second direction at least partially intersects with a projection of the junction box in the thickness direction of the cell body. By way of such design, the projection of the extending portion in the first direction intersects with the projection of the junction box in the thickness direction, so that one end of the extending portion extends to a position corresponding to the junction box. In this way, during wiring, the connecting portion can be connected to the junction box by distributing the connecting portion in the first direction, thereby improving convenience of the wiring operation.

In some embodiments, the solar cell module further includes a first insulating layer. The first insulating layer is disposed on at least one surface of the extending portion in the thickness direction of the cell body. By way of such design, the first insulating layer is disposed on the at least one surface of the extending portion, so that effective insulation protection can be implemented on an extending part of the busbar.

In some embodiments, the solar cell module further includes a second insulating layer. The second insulating layer is disposed around an outer periphery of the cell body and is connected to two ends of the first insulating layer. By way of such design, by introducing the second insulating layer, a periphery of the cell body is effectively encapsulated and insulated, which is beneficial to improving structural stability of the solar cell module.

In some embodiments, the solar cell module further includes an insulating film. The insulating film is disposed on a surface of the cell body facing toward the junction box and covers a part of each busbar located on the surface of the cell body, and the connecting portion is located on a side of the insulating film facing away from the cell body. By way of such design, the insulating film is provided to implement effective insulation protection on the part of the busbar located on the surface of the cell body. In addition, the connecting portion and the cell body are also insulated, so that the connecting portion extends from an outside to an upper part of the cell body and is connected to the junction box.

In some embodiments, the solar cell module further includes an insulating pad. The insulating pad is attached within a projection region of the junction box on the insulating film, and the connecting portion passes between the insulating pad and the insulating film and extends out of the insulating pad to connect to the junction box. By way of such design, the insulating pad is provided to cover a part of a surface of the connecting portion, thereby implementing effective insulation protection and improving stability of the solar cell module.

In some embodiments, the solar cell module further includes a cover. The cover covers the insulating film and the insulating pad. The junction box is disposed on a surface of the cover facing away from the insulating film. The connecting portion extends out of the cover and is connected to the junction box. By way of such design, the cover is provided to effectively encapsulate the cell body.

In some embodiments, the junction box includes a box body and a diode disposed in the box body. The diode is disposed in the box body, and the diode and the box body are both connected to the two busbars. An end of the connecting portion away from the extending portion is connected to at least the diode. By way of such design, the diode is provided to effectively resist a hot spot effect of the solar cell module, which is beneficial to relieving power consumption caused by a local hot spot. In addition, by using the structural design of the first busbar portion, the extending portion, and the connecting portion, while effective connection of the diode is satisfied, the diode is allowed to be disposed in the box body, thereby improving compactness of a structure.

In some embodiments, the box body is configured as an integral structure, and the end of the connecting portion away from the extending portion is connected to the diode and the box body. By way of such design, for an integral box body, the extending portion is transferred outside of one end of the cell body, such that while effective connection is satisfied, stress damage to the cell body is reduced.

In some embodiments, the box body includes two separate junction components. The two junction components are respectively disposed at the positive electrode end and the negative electrode end, and the diode is disposed in one of the two junction components. One of the busbars includes the first busbar portion, the extending portion, and the connecting portion. The first busbar portion is connected to one of the positive electrode end and the negative electrode end away from the diode, and is connected to the junction component close to the first busbar portion, and the connecting portion is connected to the diode. The other busbar is configured as a second busbar portion extending in the second direction inside the cell body. The second busbar portion is connected to one of the positive electrode end and the negative electrode end close to the diode, and is connected to the diode and the junction component having the diode inside. By way of such design, for a split-type box body, the extending portion is transferred outside of one end of the cell body, such that while the effective connection of the diode is satisfied, the diode can be disposed in the junction component, thereby improving the compactness of the structure.

In some embodiments, the solar cell module further includes an adapter. The first busbar portion is connected to one of the junction components through the adapter, and the second busbar portion is connected to the diode and the other junction component through the adapter. By way of such design, the adapter is provided, so that the junction component can be effectively connected, thereby facilitating the wiring operation.

In some embodiments, the solar cell module further includes a substrate. The cell body is disposed on the substrate, and the extending portion is located at a part of the substrate extending beyond the cell body in the second direction. By way of such design, the substrate is provided to complete encapsulation of the solar cell module.

According to a second aspect, the present application provides a photovoltaic device, and the photovoltaic device includes the solar cell module according to any one of the foregoing descriptions.

According to a third aspect, the present application provides a power consuming apparatus, and the power consuming apparatus includes the solar cell module according to any one of the foregoing descriptions.

According to a fourth aspect, the present application provides a power generation apparatus, and the power generation apparatus includes the solar cell module according to any one of the foregoing descriptions.

### BRIEF DESCRIPTION OF THE DRAWINGS

To describe the technical solutions in embodiments of the present application or conventional technologies more clearly, the following briefly describes accompanying drawings required for describing the embodiments or conventional technologies. Apparently, the accompanying drawings in the following descriptions show merely the embodiments of the present application, and a person of ordinary skill in the art may still derive other drawings from these accompanying drawings without creative efforts.
FIG. 1 is a schematic structural diagram of a solar cell module according to some embodiments of the present application;
FIG. 2 is a structural sectional view of the solar cell module in FIG. 1 taken along line A-A;
FIG. 3 is a schematic structural diagram of the solar cell module at a stage of disposing a first insulating layer and a second insulating layer according to some embodiments of the present application;
FIG. 4 is a schematic structural diagram of the solar cell module according to some other embodiments of the present application; and
FIG. 5 is a structural sectional view of the solar cell module in FIG. 4 taken along line B-B.
100, solar cell module; 10, cell body; 11, positive electrode end; 12, negative electrode end; 20, busbar; 21, first busbar portion; 22, extending portion; 23, connecting portion; 24, second busbar portion; 25, adapter; 30, insulating film; 31, insulating pad; 32, cover; 33, sealing plug; 40, first insulating layer; 41, second insulating layer; 50, substrate; 60, junction box; 61, box body; 611, junction component; 61a, first junction component; 61b, second junction component; 62, diode; X, first direction; Y, second direction; and Z, thickness direction.

### DETAILED DESCRIPTION

The technical solutions in embodiments of the present application are clearly and completely described below with reference to accompanying drawings in the embodiments of the present application. Apparently, the described embodiments are merely some rather than all of the embodiments of the present application. All other embodiments obtained by those of ordinary skill in the art based on the embodiments of the present application without creative efforts shall fall within a protection scope of the present application.

To make the foregoing objectives, features, and advantages of the present application clearer and easier to understand, the following describes specific implementations of the present application in detail with reference to the accompanying drawings. Many specific details are set forth in the following description for full understanding of the present application. However, the present application may be implemented in many other manners different from those described herein. A person skilled in the art may make similar improvement without departing from the connotation of the present application. Therefore, the present application is not limited to the specific embodiments disclosed below.

In the description of the present application, it should be understood that in case of the presence of terms "central", "longitudinal", "transversal", "length", "width", "thickness", "upper", "lower", "front", "rear", "left", "right", "vertical", "horizontal", "top", "bottom", "inner", "outer", "clockwise", "anticlockwise", "axial", "radial", "peripheral", and the like, orientations or position relationships indicated by these terms are based on orientations or position relationships shown in the accompanying drawings, and are merely for ease of describing the present application and simplifying the description, instead of indicating or implying that the mentioned apparatus or element needs to have a particular orientation, or be constructed and operated in the particular orientation. Therefore, there terms should be construed as a limitation to the present application.

In addition, in case of the presence of terms "first" and "second", these terms are used only for the purpose of description, and should not be construed as indicating or implying relative importance or implicitly specifying a quantity of indicated technical features. Therefore, a feature restricted by "first" or "second" may explicitly indicate or implicitly include at least one of such features. In the description of the present application, in case of the presence of a term "a plurality", "a plurality" means at least two, for example, two or three, unless otherwise explicitly and specifically defined.

In the present application, unless otherwise explicitly specified and defined, in case of the presence of terms such as "mount", "connect", "connection", and "fix", these terms should be understood in a broad sense. For example, the connection may be a fixed connection, or may be a detachable connection or an integral connection; the connection may be a mechanical connection or an electrical connection; and the connection may be a direct connection, an indirect connection through an intermediary, internal communication between two elements, or interaction between two elements, unless otherwise explicitly defined. Persons of ordinary skill in the art may understand specific meanings of the foregoing terms in the present application according to specific cases.

In the present application, unless otherwise explicitly specified and defined, in case of the presence of descriptions such as a first feature being "above" or "below" a second feature, it may mean that the first feature and the second feature are in direct contact, or the first feature and the second feature are in indirect contact through an intermediary. In addition, that a first feature is "on", "above", and "over" a second feature may mean that the first feature is directly above or obliquely above the second feature, or merely indicate that a horizontal height of the first feature is higher than that of the second feature. That a first feature is "under", "below", and "beneath" the second feature may mean that the first feature is directly below or obliquely below the second feature, or merely indicate that a horizontal height of the first feature is lower than that of the second feature.

It should be noted that if an element is referred to as being "fixed to" or "disposed on" another element, the element may be directly on the another element or there may be an intermediate element. When an element is considered as being "connected to" another element, the element may be directly connected to the another element or there may be an intermediate element. If any, the terms "vertical", "horizontal", "upper", "lower", "left", "right" and similar expressions used in the present application are used only for the purpose of description, and do not indicate the only implementation.

With the rapid development of science and technology, breakthroughs have been made in the development of new energy. For example, solar cells represented by perovskite and organic thin-film cells have made subversive progress, and these solar cells are expected to become mainstream products in solar cells because of their advantages of high efficiency and low cost.

In a photovoltaic module, to implement an electrical connection to an external device, a junction box is typically disposed on a cell body in the photovoltaic module. During the connection of the junction box, a busbar, such as a copper tape, is typically disposed on a positive electrode end and a negative electrode end of the cell body. Because the junction box is located between the positive electrode end and the negative electrode end, a part of the busbar is distributed on the surface of the cell body in a direction from the positive electrode end to the negative electrode end. In addition, the part of the busbar distributed in the direction from the positive electrode end to the negative electrode end needs to be insulated from the cell body, so an insulating tape is typically disposed between the busbar and the cell body.

However, due to the presence of the insulating tape and the busbar on the surface of the cell body, during subsequent lamination, stress concentration may occur to the cell body, which easily causes damage to an internal structure of the cell body, thereby accelerating degradation of the internal structure of the cell body and affecting stability of the module.

Based on this, to resolve a problem that damage from stress concentration in the conventional solar cell module affects the structural stability, the present application provides a solar cell module. Two busbars are used to respectively connect the junction box to the positive electrode end and the negative electrode end of the cell body, so as to realize electrical connection between the junction box and the cell body. During structural design of the busbars, at least one busbar can be designed to include a first busbar portion, an extending portion, and a connecting portion. The extending portion is located outside of one end of the cell body in a second direction. It can be seen therefrom that when electrically connected to the junction box, the extending portion is led outside of one end of the cell body, such that a distribution of a part of the busbar located between the positive electrode end or the negative electrode end and the junction box on a surface of the cell body is reduced, thus reducing probability of stress concentration caused by the busbar to the cell body, and improving stability of the solar cell module.

It should be noted that the cell body refers to a component that converts light energy into electric energy in the solar cell module. For ease of understanding, using a perovskite solar cell module as an example, the cell body may include substrate glass, a transparent conductive layer, an electron transport layer, a perovskite layer, a hole transport layer, and metal electrodes.

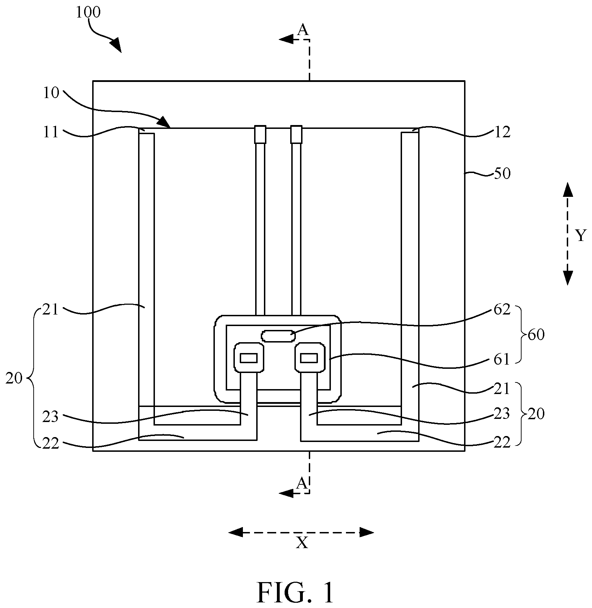

In some embodiments of the present application, referring to FIG. 1, the present application provides a solar cell module 100. The solar cell module 100 includes a cell body 10, a junction box 60, and two busbars 20. The cell body 10 includes a positive electrode end 11 and a negative electrode end 12 spaced in a first direction X. The junction box 60 is located on a side of the cell body 10 in a thickness direction Z of the cell body. The two busbars 20 are respectively correspondingly connected to the positive electrode end 11 and the negative electrode end 12, and both electrically connected to the junction box 60. At least one of the two busbars 20 includes a first busbar portion 21, an extending portion 22, and a connecting portion 23 sequentially connected. The first busbar portion 21 is connected to the positive electrode end 11 and/or the negative electrode end 12. The extending portion 22 is located outside of one end of the cell body 10 in a second direction Y. The connecting portion 23 is connected to the extending portion 22 and the junction box 60. The first direction X, the second direction Y, and the thickness direction Z of the cell body 10 intersect pairwise. The first direction X, the second direction Y, and the thickness direction Z of the cell body 10 are not coplanar.

The cell body 10 refers to a component that converts light energy into electric energy in the solar cell module 100, and two ends of the cell body 10 in the first direction X are respectively the negative electrode end 12 and the positive electrode end 11. The junction box 60 is a core part that mainly communicates an inside and an outside of the module and effectively leads out electric energy. Connection of the junction box 60 to the cell body 10 may be achieved by connecting the busbars 20 to the positive electrode end 11 and the negative electrode end 12, respectively.

The busbar 20 refers to a structure having an electrical conduction function, and is used for leading electric energy out of or into the cell body 10. For example, the busbar 20 may be, but is not limited to, a copper tape. At least one of the two busbars 20 includes the first busbar portion 21, the extending portion 22, and the connecting portion 23. The first busbar portion 21 refers to a structure connected to the positive electrode end 11 or the negative electrode end 12, and is used for leading electric energy out of or into the cell body 10. The extending portion 22 refers to a structure of the busbar 20 located outside of one end of the cell body 10 in the second direction Y. In this way, the connecting portion 23 may extend from an outside of one end of the cell body 10 in the second direction Y into the cell body 10 and be connected to the junction box 60. Compared with the positive electrode end 11 or the negative electrode end 12 that directly extends to the junction box 60 in the second direction Y, in this embodiment, the extending portion 22 is led outside of the cell body 10, so that the conventional transverse busbar 20 and the insulating tape can be partially or totally omitted, thereby reducing stress damage to the cell body 10. In addition, a diode 62 may or may not be disposed inside the junction box 60. When the diode 62 is disposed inside the junction box 60, the connecting portion 23 may be electrically connected to the diode 62, or may be electrically connected to another component in the junction box 60. A specific wiring manner may be determined according to wiring requirements of the junction box 60.

When the diode 62 is disposed in the junction box 60, the diode 62 may function to resist a hot spot effect. For example, the diode 62 is connected in parallel to the positive electrode end 11 and the negative electrode end 12. When the solar cell module 100 is shaded, the diode 62 operates, interrupting a current flow through the solar cell module 100 and reducing the heat generated by the solar cell module 100. In addition, when only one of the two busbars 20 includes the first busbar portion 21, the extending portion 22, and the connecting portion 23, the other busbar 20 can be connected to the junction box 60 in a conventional connection manner. Certainly, the junction box 60 may also be directly moved to one of the busbars 20, to shorten a connection path between the junction box 60 and the busbar 20.

The extending portion 22 is located outside of one end of the cell body 10 in the second direction Y, and one end of the extending portion 22 may extend to a position corresponding to the junction box 60 in the first direction X. In this way, the connecting portion 23 can be connected to the junction box 60 simply by extending in the first direction X. Certainly, alternatively, the connecting portion 23 may extend in the second direction Y but does not extend to the position corresponding to the junction box 60 in the first direction X. In this case, the connecting portion 23 may extend, in an inclined direction, from the outside of the cell body 10 to be connected to the junction box 60.

In addition, it should be further noted that the first direction X and the second direction Y in this embodiment are both direction concepts introduced when the cell body 10 is in a flattened state. Therefore, if the solar cell module 100 is a flexible curved cell, the solar cell module 100 may be re-flattened, to determine respective directions corresponding to the first direction X and the second direction Y on the cell body 10.

It can be seen therefrom that when electrically connected to the junction box 60, the extending portion 22 is led outside of one end of the cell body 10, such that a distribution of a part of the busbar 20 located between the positive electrode end 11 or the negative electrode end 12 and the junction box 60 on a surface of the cell body 10 is reduced, thus reducing probability of stress concentration caused by the busbar 20 to the cell body 10, and improving stability of the solar cell module 100.

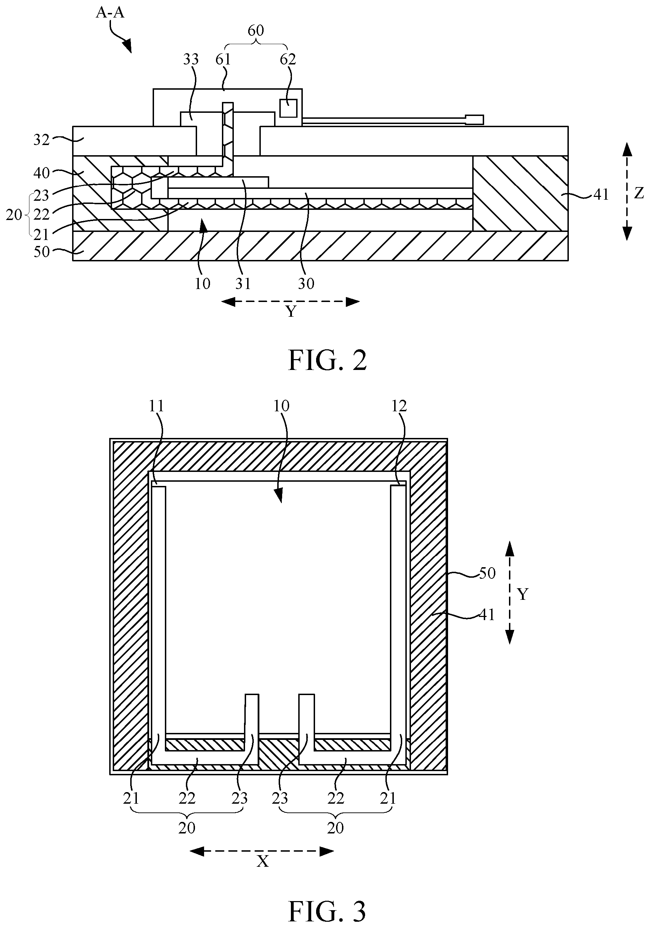

In some embodiments of the present application, referring to FIG. 1 and FIG. 2, the extending portion 22 extends in the first direction X, and a projection of one end of the extending portion 22 connected to the connecting portion 23 in the second direction Y at least partially intersects with a projection of the junction box 60 in the thickness direction Z of the cell body 10.

An objective of the projection of one end of the extending portion 22 connected to the connecting portion 23 in the second direction Y is to enable one end of the extending portion 22 to extend to the position corresponding to the junction box 60 in the second direction Y. It should be noted that in some embodiments, the extending portion 22 extends outward from the surface of the cell body 10, and the junction box 60 may be disposed on a surface of a cover 32 covering the cell body 10. Therefore, there may be a difference between the extending portion 22 and the junction box 60 in the thickness direction Z of the cell body 10. As a result, in this embodiment, the projection of the junction box 60 in the thickness direction Z of the cell body 10 is used as a reference. When the projection of one end of the extending portion 22 in the first direction X intersects with the projection of the junction box 60, it indicates that one end of the extending portion 22 may extend to the required position corresponding to the junction box 60 in the first direction X. Specifically, in some examples, the first direction X, the second direction Y, and the thickness direction Z of the cell body 10 are mutually perpendicular.

A shape of the extending portion 22 outside of one end of the cell body 10 may be designed in many ways. For example, the extending portion 22 linearly extends in the second direction Y to present a linear structure. Alternatively, the extending portion 22 extends in a curved path in the second direction Y. For example, the extending portion 22 presents a curved structure that arches toward a side facing away from the cell body 10.

In addition, the extending portion 22 and the connecting portion 23 may be connected by snap-fit, adhesion, bolting, soldering, or the like. The extending portion and the connecting portion may also be designed as an integral structure. For example, a part of the busbar 20 extends in the second direction Y to form the extending portion 22, and is bent at one end of the extending portion 22 toward one side of the cell body 10 to form the connecting portion 23. Certainly, the connecting portion 23 and the extending portion 22 may be integrally formed by using a 3D printing technology, die casting, or extrusion. Specifically, in some embodiments, the busbar portion, the extending portion 22, and the connecting portion 23 are an integral structure.

By way of such design, the projection of the extending portion 22 in the first direction X intersects with the projection of the junction box 60 in the thickness direction Z, so that one end of the extending portion 22 extends to the position corresponding to the junction box 60. In this way, during wiring, the connecting portion 23 can be connected to the junction box 60 by distributing the connecting portion in the first direction X, thereby improving convenience of the wiring operation.

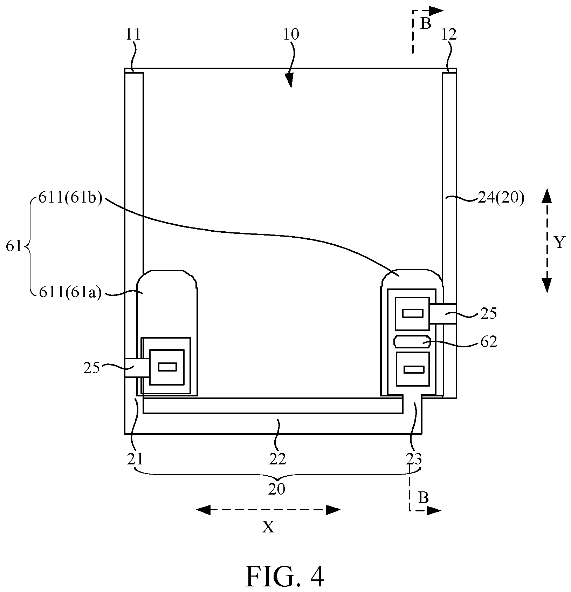

In some embodiments of the present application, referring to FIG. 3 and FIG. 4, the solar cell module 100 further includes a first insulating layer 40. The first insulating layer 40 is disposed on at least one surface of the extending portion 22 in the thickness direction Z of the cell body 10.

The first insulating layer 40 may be disposed below the extending portion 22, or may be disposed above the extending portion 22. Certainly, there may be two first insulating layers 40 respectively located above and below the extending portion 22. When the first insulating layer 40 is disposed below the extending portion 22, a thickness of the first insulating layer 40 can be designed to allow a top surface of the extending portion 22 to be flush or approximately flush with a top surface of the cell body 10, to reduce a height difference between the extending portion 22 and the cell body 10, so that the connecting portion 23 can better extend from an outside to the top surface of the cell body 10. For example, the thickness of the first insulating layer may be, but is not limited to, 0.2 mm to 0.6 mm, for example, 0.4 mm.

In addition, when the first insulating layers 40 are respectively disposed on two surfaces of the extending portion 22, during a preparation process, the first insulating layer 40 may be first attached to the outside of one end of the cell body 10 in the second direction Y. The first insulating layer 40 extends in the first direction X. Next, the extending portion 22 is attached to a surface of the first insulating layer 40, so that the extending portion 22 reaches the position corresponding to the junction box 60. Finally, a surface of the extending portion 22 is covered with the first insulating layer 40, and the upper and lower first insulating layers 40 are controlled to overlap with each other.

There are a plurality of options for a material of the first insulating layer 40, which may be, for example, but not limited to, butyl rubber or silicone.

By way of such design, the first insulating layer 40 is disposed on the at least one surface of the extending portion 22, so that effective insulation protection can be implemented on the extending part of the busbar 20.

In some embodiments of the present application, referring to FIG. 3 and FIG. 4, the solar cell module 100 further includes a second insulating layer 41. The second insulating layer 41 is disposed around an outer periphery of the cell body 10 and is connected to two ends of the first insulating layer 40.

The second insulating layer 41 and the first insulating layer 40 can be connected to each other to form an encapsulation space, so that the outer periphery of the cell body 10 is effectively encapsulated, and insulation protection on the periphery of the cell body 10 is also implemented. The second insulating layer 41 and the first insulating layer 40 may be made of the same or different materials. For example, the first insulating layer 40 and the second insulating layer 41 may be, but are not limited to, butyl rubber.

By way of such design, by introducing the second insulating layer 41, a periphery of the cell body 10 is effectively encapsulated and insulated, which is beneficial to improving structural stability of the solar cell module 100.

According to some embodiments of the present application, referring to FIG. 2, the solar cell module 100 further includes an insulating film 30. The insulating film 30 is disposed on a surface of the cell body 10 facing toward the junction box 60 and covers a part of each busbar 20 located on the surface of the cell body 10. The connecting portion 23 is located on a side of the insulating film 30 facing away from the cell body 10.

When one of the busbars 20 includes the first busbar portion 21, the extending portion 22, and the connecting portion 23, after being disposed on the surface of the cell body 10, the insulating film 30 may cover the first busbar portion 21 of the busbar 20, but does not cover the extending portion 22 and the connecting portion 23 of the busbar 20. For example, the insulating film 30 covers the first busbar portion 21, and the extending portion 22 and the connecting portion 23 are not covered. In this case, the connecting portion 23 may extend to a side of the insulating film 30 facing away from the cell body 10, so that the connecting portion 23 is insulated from the cell body 10. When the busbar 20 is completely located within the surface of the cell body 10, the insulating film 30 may cover the entire busbar 20. Specifically, in some embodiments, the insulating film 30 completely covers the surface of the cell body 10.

It should be noted that there are a plurality of options for a material of the insulating film 30, which only needs to be capable of achieving a volume resistivity of ≥ 10¹⁵Ω·cm and an adhesion strength to tempered cover glass of ≥ 60 N/cm. The material may be, for example, thermoplastic polyolefin (TPO), polyolefin elastomer (POE), ethylene vinyl acetate copolymer (EVA), polyvinyl butyral (PVB), or thermoplastic polyurethane (TPU) and the like.

By way of such design, the insulating film 30 is provided to implement effective insulation protection on the part of the busbar 20 located on the surface of the cell body 10. In addition, the connecting portion 23 and the cell body 10 are also insulated, so that the connecting portion 23 extends from the outside to the upper part of the cell body 10 and is connected to the junction box 60.

According to some embodiments of the present application, referring to FIG. 2, the solar cell module 100 further includes an insulating pad 31. The insulating pad 31 is attached within a projection region of the junction box 60 on the insulating film 30, and the connecting portion 23 passes between the insulating pad 31 and the insulating film 30 and extends out of the insulating pad 31 to connect to the junction box 60.

The connecting portion 23 extends from the outside of one end of the cell body 10 to the surface of the insulating film 30, and extends on the surface of the insulating film 30 into the projection region of the junction box 60 on the insulating film 30. In this case, a surface of the connecting portion 23 facing away from the insulating film 30 is directly exposed below the junction box 60, which is not beneficial to insulation protection. Therefore, the insulating pad 31 is disposed in the projection region of the junction box 60 on the insulating film 30, so that the insulating pad 31 covers at least a part of the surface of the connecting portion 23. Because the connecting portion 23 needs to be connected to the junction box 60, one end of the connecting portion 23 further needs to extend through the insulating pad 31. Certainly, in some embodiments, the insulating pad 31 may further extend in the second direction Y to an end of the cell body 10 close to the extending portion 22, to insulate and cover a larger part of the connecting portion 23.

There are also a plurality of options for a material of the insulating pad 31, as long as effective insulation (a volume resistivity of ≥ 10¹⁴Ω·cm) can be implemented. The material may be, for example, but is not limited to, polymethyl methacrylate (PMMA), polyethylene glycol terephthalate (PET), polyimide (PI), polycarbonate (PC), or polyvinyl butyral (PVB) and the like.

By way of such design, the insulating pad 31 is provided to cover a part of the surface of the connecting portion 23, thereby implementing effective insulation protection and improving stability of the solar cell module 100.

According to some embodiments of the present application, referring to FIG. 2, the solar cell module 100 further includes a cover 32. The cover 32 covers the insulating film 30 and the insulating pad 31. The junction box 60 is disposed on a surface of the cover 32 facing away from the insulating film 30. The connecting portion 23 extends out of the cover 32 and is connected to the junction box 60.

The cover 32 is a structure covering the top surface of the cell body 10, and also provides structural support for installation of the junction box 60. The cover 32 may be a transparent structure, for example, but not limited to, glass.

In addition, because the junction box 60 is disposed on a side of the cover 32 facing away from the insulating film 30, the cover 32 needs to be provided with openings, so that the busbars 20 can pass through the cover 32 and be connected to the junction box 60. In this case, to reduce infiltration of water and oxygen, sealing plug 33 may be inserted into openings of the cover 32.

By way of such design, the cover 32 is provided to effectively encapsulate the cell body 10.

According to some embodiments of the present application, referring to FIG. 2, the junction box 60 includes a box body 61 and a diode 62 disposed in the box body 61. The diode 62 is disposed in the box body 61, and the diode 62 and the box body 61 are both connected to the two busbars 20. An end of the connecting portion 23 away from the extending portion 22 is connected to at least the diode 62.

The box body 61 refers to a main component in the junction box 60 that communicates an inside and an outside of the module and effectively leads out electric energy. The box body 61 may be designed as an integral structure, and may be disposed between the positive electrode end 11 and the negative electrode end 12 or at the positive electrode end 11 or the negative electrode end 12. When the box body 61 is disposed at the positive electrode end 11 or the negative electrode end 12, the box body 61 may be directly connected to the busbar 20 close to the box body, and a junction structure extending in the first direction X between the busbar 20 and the box body 61 can be omitted or shortened. In addition, the box body 61 may further be designed as a split structure. For example, the box body 61 may include two parts, where one part may be disposed at the positive electrode end 11, and the other part may be disposed at the negative electrode end 12. In this way, stress damage caused to the cell body 10 by the part of the busbar 20 extending in the first direction X can be effectively relieved. In addition, if the box body 61 is divided into two parts and the diode 62 may be disposed in one of the two parts, it means that the diode 62 may be directly connected to one of the positive electrode end 11 and the negative electrode end 12, but has a particular spacing with the other of the positive electrode end 11 and the negative electrode end 12 in the first direction X. In this case, the busbar 20 away from the diode 62 can be designed to include the first busbar portion 21, the extending portion 22, and the connecting portion 23.

The diode 62 refers to a device that is connected in parallel to the positive electrode end 11 and the negative electrode end 12 together with the box body 61 and can function to resist a hot spot effect. Disposing the diode 62 in the box body 61 can reduce occupation of space outside the junction box 60, so that the structure is more compact. The diode 62 needs to be connected to the positive electrode end 11 and the negative electrode end 12. Therefore, no matter where the diode 62 is located in the cell body 10, the diode maintains a spacing with the positive electrode end 11 and/or the negative electrode end 12 in the first direction X. In this way, to reduce easy stress damage caused by the extension of the busbar 20 in the first direction X to the inside of the module, the at least one busbar 20 is designed to include the first busbar portion 21, the extending portion 22, and the connecting portion 23, so that the part of the busbar 20 extending in the first direction X is transferred outside of one end of the cell body 10.

In addition, it should be noted that FIG. 2 merely shows a schematic structural diagram of the box body 61 and the diode 62 and does not show the respective specific structures. In addition, specific connection circuits of the box body 611 and the diode 62 are not objects to be improved in the present application, and reference may be made to an existing connection manner. Therefore, the specific connection circuits of the box body 611 and the diode 62 are not shown in FIG. 2.

By way of such design, the diode 62 is provided to effectively resist the hot spot effect of the solar cell module 100, which is beneficial to relieving power consumption caused by a local hot spot. In addition, by using the structural design of the first busbar portion 21, the extending portion 22, and the connecting portion 23, while the effective connection of the diode 62 is satisfied, the diode 62 is allowed to be disposed in the box body 61, thereby improving compactness of the structure.

According to some embodiments of the present application, referring to FIG. 1, the box body 61 is configured as an integral structure, and the end of the connecting portion 23 away from the extending portion 22 is connected to the diode 62 and the box body 61.

The integral structure refers to a structure integrated in a same housing to form a whole. In this case, the box body 61 may be disposed at the positive electrode end 11 or at the negative electrode end 12. Certainly, the box body 61 may also be disposed between the positive electrode end 11 and the negative electrode end 12.

When the box body 61 is disposed at the positive electrode end 11, there is a spacing between the box body 61 and the negative electrode end 12. To reduce stress damage of the busbar 20 to the cell body 10, the busbar 20 connected to the negative electrode end 12 can be designed to include the first busbar portion 21, the extending portion 22, and the connecting portion 23. When the box body 61 is disposed at the negative electrode end 12, the busbar 20 connected to the positive electrode end 11 can be designed to include the first busbar portion 21, the extending portion 22, and the connecting portion 23. Moreover, when the box body 61 is located between the positive electrode end 11 and the negative electrode end 12, the two busbars 20 can each be designed to include the first busbar portion 21, the extending portion 22, and the connecting portion 23.

In addition, because the box body 61 is an integral structure, when the diode 62 is disposed at the junction box 60, a wiring manner of the diode 62 may be consistent with that of the box body 61.

For ease of understanding, the junction box 60 located between the positive electrode end 11 and the negative electrode end 12 may be described experimentally. For example, in Comparative Embodiment 1, a copper tape is attached to the positive electrode end 11 and the negative electrode end 12, and a copper tape is also attached to the surface of the cell body 10 in the first direction X, so that the copper tapes are connected to the junction box 60. In Embodiment 1, the two busbars 20 are each designed to include the first busbar portion 21, the extending portion 22, and the connecting portion 23, and the first busbar portion 21, the extending portion 22, and the connecting portion 23 are all copper tapes. For other structures of the solar cell module 100, Embodiment 1 and Comparative Embodiment 1 are the same.

The following stability tests were performed on Embodiment 1 and Comparative Embodiment 1.
(1) IV test: Using a Class AAA solar simulator as a light source and a high-precision source meter as a test device, current and voltage data was collected at a scan voltage ranging from -0.5 V to 48 V with a data collection delay of 20 ms. The program plotted an I-V curve with the voltage on a horizontal axis and the current on a vertical axis. An intercept of the horizontal axis was the open-circuit voltage Voc, and an intercept of the vertical axis was the short-circuit current Jsc. The product of I and V on the IV curve was power under a corresponding load, and a ratio of the maximum power to irradiation power of the solar simulator was PCE. Multiple pieces of data of the same experimental condition were averaged.
(2) PL test: In the photoluminescence (PL) test, the module was placed on a photoluminescence imaging device and irradiated by using 502 nm light as excitation light, and a dedicated camera was used to collect images at a photoluminescence intensity of 700 nm to 900 nm on a 2D plane.
(3) EL test: In the electroluminescent (EL) test, the module was placed on an electroluminescent imaging device, and positive and negative lines were connected to ports on the device. A source meter was adjusted. An applied current of 300 mA was input at 44 V, and a dedicated camera was used to collect images at a photoluminescence intensity of 700 nm to 900 nm on a 2D plane.
(4) UV-TC sequence test: Referring to IEC 61215-2:2021 MQT10, first, the device was placed in an ultraviolet aging box whose temperature was controlled at 60°C, irradiated under a light source with an irradiance of 250 W/m² at 280 nm to 400 nm for 60 h, and then transferred to a thermal cycling test chamber. Referring to IEC 61215-2:2021 MQT11, a thermal cycling test from -40°C to 85°C, with a temperature increase and decrease rate of 1°C/min and a dwell time of 45 min at both 85°C and -40°C, was performed for a total of 200 cycles. After the device was taken out and allowed to recover at room temperature for one hour, a visual inspection was performed, and IV, PL, and EL after aging were measured.

A photoelectric conversion efficiency loss rate (PCE loss rate) before and after the UV-TC sequence test was calculated according to the following formula:
$PCE loss rate = \frac{{PCE}_{before aging} - {PCE}_{after aging}}{{PCE}_{before aging}}$

The result of visual inspection was recorded.

(5) DH test: An IV test was performed on the perovskite photovoltaic modules obtained in Embodiment 1 and Comparative Embodiment 1 to obtain photoelectric conversion efficiency before the damp-heat test.

Then, the damp-heat test (MQT 13) stipulated by the IEC61215:2021 standard was performed. The test method included: The positive and negative electrode ends of the junction box of the perovskite photovoltaic module were shorted. The perovskite photovoltaic module was placed into a constant-temperature and constant-humidity chamber with a temperature of 85±2°C and a humidity of 85±5%RH. After every 500 h of aging, the program was set to cool the module at a rate of 1.5°C/min. After approximately 40 min, when recovering to room temperature, the module was further allowed to recover with an open circuit for 2 hours at 23±5°C and below 75%RH. Then, a visual inspection was performed, and the IV test, PL imaging test, and EL imaging test after aging were performed. Then, the module was placed back into the constant-temperature and constant-humidity chamber for further aging until the PCE decreased to less than 80% of the initial value and the visual inspection revealed yellowing abnormalities of the module, and the test was stopped. A total aging duration when the PCE decreased to less than 80% of the initial value for the first time was recorded as T₈₀, and a total aging duration when the visual inspection revealed yellowing abnormalities of the module for the first time was recorded as T _{water ingress}.

The test results are as follows:

| | Comparative Embodiment 1 | Embodiment 1 |
|---|---|---|
| Abnormalities under busbar in PL image under UV-TC sequence test | Present | Absent |
| Abnormalities under busbar in EL image under UV-TC sequence test | Present | Absent |
| PCE loss rate under UV-TC sequence test | 6.75% | 2.17% |
| Abnormalities under busbar in PL image under DH test | Present | Absent |
| Abnormalities under busbar in EL image under DH test | Present | Absent |
| T₈₀ under DH test | 4600 h | 6270 h |
| T _{water ingress} under DH test | 5700 h | 5700 h |

It can be seen from the above that the solution of Embodiment 1 effectively resolves the problem of stress damage under the busbar 20 on the premise of no loss of T _{water ingress} under the DH test and obtains better results in both the UV-TC sequence test and the DH test.

This indicates that transferring a part of the busbar 20 outside of one end of the cell body 10 can effectively reduce the stress damage of the cell body 10, alleviate the degradation of the internal structure of the cell body 10, and improve stability of the module.

By way of such design, for an integral box body 61, the extending portion 22 is transferred outside of one end of the cell body 10, and while the effective connection is satisfied, stress damage to the cell body 10 is reduced.

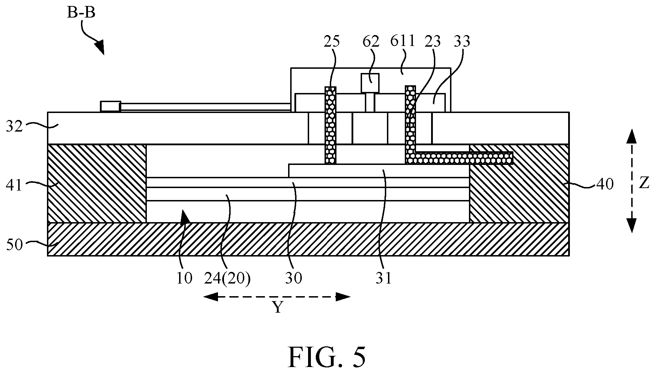

According to some embodiments of the present application, referring to FIG. 4 and FIG. 5, the box body 61 includes two separate junction components 611. The two junction components 611 are respectively disposed at the positive electrode end 11 and the negative electrode end 12. The diode 62 is disposed in one of the two junction components 611. One of the busbars 20 includes the first busbar portion 21, the extending portion 22, and the connecting portion 23. The first busbar portion 21 is connected to one of the positive electrode end 11 and the negative electrode end 12 away from the diode 62, and is connected to the junction component 611 close to the first busbar portion. The connecting portion 23 is connected to the diode 62. The other busbar 20 is configured as a second busbar portion 24 extending in the second direction Y inside the cell body 10. The second busbar portion 24 is connected to one of the positive electrode end 11 and the negative electrode end 12 close to the diode 62, and is connected to the diode 62 and the junction component 611 having the diode 62 inside.

When the box body 61 is designed as a split structure, for example, two junction components 611, the two junction components 611 are respectively disposed at the positive electrode end 11 and the negative electrode end 12, so that a wiring distance between the junction component 611 and the positive electrode end 11 or the negative electrode end 12 can be shortened. Because the diode 62 needs to be connected to both the positive electrode end 11 and the negative electrode end 12, in the conventional wiring manner, the diode 62 is disposed outside of the box body 61, and the busbar is disposed alone, to complete the connection of positive and negative ends of the diode 62. However, this manner results in a large number of external devices of the module and a large space occupation.

Therefore, in this embodiment, one of the busbars 20 is designed to include the first busbar portion 21, the extending portion 22, and the connecting portion 23. The second busbar portion 24 is a structure that is located within the surface of the cell body 10 and extends in the second direction Y. In this way, while the effective connection of the diode 62 is satisfied, the diode 62 can be integrated in the junction component 611.

For ease of understanding, referring to FIG. 4, in an example where the two junction components 611 are respectively a first junction component 61a and a second junction component 61b and the diode 62 is disposed inside the second junction component 61b, the first junction component 61a is disposed at the positive electrode end 11, and the second junction component 61b is disposed at the negative electrode end 12. In this case, the busbar 20 close to the first junction component 61a may include the first busbar portion 21, the extending portion 22, and the connecting portion 23, and the busbar 20 close to the second junction component 61b may be designed as the second busbar portion 24. The first busbar portion 21 is connected to the first junction component 61a, and the second busbar portion 24 is connected to the second junction component 61b and the diode 62, so that the second junction component 61b and the diode 62 are respectively connected to the negative electrode end 12. The connection between the diode 62 and the positive electrode end 11 is completed by using the extending portion 22 and the connecting portion 23. In this case, the extending portion 22 extends, outside of one end of the cell body 10, in the first direction X from the positive electrode end 11 to the negative electrode end 12.

In addition, it should be noted that FIG. 5 merely shows a schematic structural diagram of the box body 61 and the diode 62, and does not show respective specific structures. In addition, specific connection circuits of the box body 611 and the diode 62 are not objects to be improved in the present application, and reference may be made to an existing connection manner. Therefore, the specific connection circuits of the box body 611 and the diode 62 are not shown in FIG. 5.

By way of such design, for the split-type box body 61, the extending portion 22 is transferred outside of one end of the cell body 10, such that while the effective connection of the diode 62 is satisfied, the diode 62 may be disposed in the junction component 611, thereby improving compactness of the structure.

According to some embodiments of the present application, referring to FIG. 4 and FIG. 5, the solar cell module 100 further includes an adapter 25. The first busbar portion 21 is connected to one of the junction components 611 through the adapter 25, and the second busbar portion 24 is connected to the diode 62 and the other junction component 611 through the adapter 25.

The adapter 25 refers to a component that implements an electrical connection between the junction component 611 and the first busbar portion 21 or the second busbar portion 24, which may be, but not limited to, a copper tape. The adapter 25 may be fixed to the first busbar portion 21 or the second busbar portion 24 by soldering, snap-fit, or the like. Certainly, the adapter 25 may also form an integral structure with the first busbar portion 21 or the second busbar portion 24, for example, being integrally formed by cutting or extrusion.

By way of such design, the adapter 25 is provided, so that the junction component 611 can be effectively connected, thereby facilitating the wiring operation.

According to some embodiments of the present application, referring to FIG. 2, the solar cell module 100 further includes a substrate 50. The cell body 10 is disposed on the substrate 50, and the extending portion 22 is located at a part of the substrate 50 that extends beyond the cell body 10 in the second direction Y.

The substrate 50 is also referred to as a base or a backing. A material of the substrate 50 may be, but not limited to, glass, tempered glass, quartz, an organic flexible material, or the like. To facilitate encapsulation of the cell body 10, a periphery of the substrate 50 all needs to extend beyond the cell body 10. For example, during the preparation of the solar cell module 100, after the cell body 10 is formed on the substrate 50, edge cleaning of the periphery of the cell body 10 may be performed to expose the substrate 50.

By way of such design, the substrate 50 is provided to complete encapsulation of the solar cell module 100.

According to some embodiments of the present application, the present application provides a photovoltaic device, and the photovoltaic device includes the solar cell module 100 according to any one of the foregoing descriptions.

According to some embodiments of the present application, the present application provides a power consuming apparatus, and the power consuming apparatus includes the solar cell module 100 according to any one of the foregoing descriptions.

According to some embodiments of the present application, the present application provides a power generation apparatus, and the power generation apparatus includes the solar cell module 100 according to any one of the foregoing descriptions.

The power generation apparatus refers to a power generation system that uses the photovoltaic effect to directly convert solar energy into electric energy, and is classified into a stand-alone PV system and a grid-connected PV system. The stand-alone PV system includes a solar photovoltaic array including photovoltaic modules, a battery bank, a charging controller, a power electronic converter (inverter), a load, and the like. The grid-connected PV system includes a photovoltaic array, a high frequency DC/DC boosting circuit, a power electronic converter (inverter), and a system monitoring part.

According to some embodiments of the present application, referring to FIG. 1 to FIG. 5, the present application provides the solar cell module 100. The solar cell module 100 includes the cell body 10, the junction box 60, and the busbars 20. The junction box 60 includes the box body 61 and the diode 62. The box body 61 may be an integral structure or a split structure. When the box body 61 is an integral structure, the two busbars 20 each include the first busbar portion 21, the extending portion 22, and the connecting portion 23. The two first busbar portions 21 are respectively attached to the positive electrode end 11 and the negative electrode end 12 of the cell body 10. The extending portion 22 is located outside of one end of the cell body 10, and one end of the extending portion 22 extends to the position where the junction box 60 is located. One end of the connecting portion 23 is connected to the extending portion 22, and the other end is connected to the box body 61 and the diode 62.

When the box body 61 includes the two separate junction components 611, one of the busbars 20 includes the first busbar portion 21, the extending portion 22, and the connecting portion 23, and the other busbar 20 is the second busbar portion 24 located on the surface of the cell body 10. The two junction components 611 are respectively disposed at the positive electrode end 11 and the negative electrode end 12. The first busbar portion 21 is connected to the junction component 611 close to the first busbar portion. The second busbar portion 24 is connected to the junction component 611 close to the second busbar portion and the diode 62, and the connecting portion 23 is also connected to the diode 62.

The technical features described above in the embodiments may be combined in any manner. For brevity, not all possible combinations of the technical features in the above embodiments are described. However, as long as such combinations of the technical features do not contradict each other, they should be considered within the scope disclosed in this specification.

The foregoing embodiments merely describe several implementations of the present application. The descriptions are relatively specific and detailed, but are not to be understood as limitations to the scope of the present application. It should be noted that, for those skilled in the art, various modifications and improvements can be made without departing from the concept of the present application, and all such modifications and improvements shall fall within the protection scope of the present application. Therefore, the protection scope of the patent of the present application shall be subject to the appended claims.

## Claims

1. A solar cell module, comprising:
a cell body, comprising a positive electrode end and a negative electrode end spaced in a first direction;
a junction box, located on a side of the cell body in a thickness direction of the cell body; and
two busbars, respectively correspondingly connected to the positive electrode end and the negative electrode end, and both electrically connected to the junction box, wherein
at least one of the two busbars comprises a first busbar portion, an extending portion, and a connecting portion sequentially connected, the first busbar portion being connected to the positive electrode end and/or the negative electrode end, the extending portion being located outside of one end of the cell body in a second direction, and the connecting portion being connected to the extending portion and the junction box; and the first direction, the second direction, and the thickness direction of the cell body intersect pairwise, and the first direction, the second direction, and the thickness direction of the cell body are not coplanar.

2. The solar cell module according to claim 1, wherein the extending portion extends in the first direction, and a projection of an end of the extending portion connected to the connecting portion in the second direction at least partially intersects with a projection of the junction box in the thickness direction of the cell body.

3. The solar cell module according to claim 1 or 2, wherein the solar cell module further comprises a first insulating layer, the first insulating layer being disposed on at least one surface of the extending portion in the thickness direction of the cell body.

4. The solar cell module according to claim 3, wherein the solar cell module further comprises a second insulating layer, the second insulating layer being disposed around an outer periphery of the cell body and being connected to two ends of the first insulating layer.

5. The solar cell module according to any one of claims 1 to 4, wherein the solar cell module further comprises an insulating film, the insulating film being disposed on a surface of the cell body facing toward the junction box and covering a part of each busbar located on the surface of the cell body, and the connecting portion being located on a side of the insulating film facing away from the cell body.

6. The solar cell module according to claim 5, wherein the solar cell module further comprises an insulating pad, the insulating pad being attached within a projection region of the junction box on the insulating film, and the connecting portion passing between the insulating pad and the insulating film and extending out of the insulating pad to connect to the junction box.

7. The solar cell module according to claim 6, wherein the solar cell module further comprises a cover, the cover covering the insulating film and the insulating pad, the junction box being disposed on a surface of the cover facing away from the insulating film, and the connecting portion extending out of the cover and being connected to the junction box.

8. The solar cell module according to any one of claims 1 to 7, wherein the junction box comprises a box body and a diode disposed in the box body, the diode being disposed in the box body, and the diode and the box body being both connected to the two busbars, wherein
an end of the connecting portion away from the extending portion is connected to at least the diode.

9. The solar cell module according to claim 8, wherein the box body is configured as an integral structure, and the end of the connecting portion away from the extending portion is connected to the diode and the box body.

10. The solar cell module according to claim 8, wherein the box body comprises two separate junction components, the two junction components being respectively disposed at the positive electrode end and the negative electrode end, and the diode being disposed in one of the two junction components;
one of the busbars comprises the first busbar portion, the extending portion, and the connecting portion, the first busbar portion being connected to one of the positive electrode end and the negative electrode end away from the diode, and being connected to the junction component close to the first busbar portion, and the connecting portion being connected to the diode; and
the other busbar is configured as a second busbar portion extending in the second direction inside the cell body, the second busbar portion being connected to one of the positive electrode end and the negative electrode end close to the diode, and being connected to the diode and the junction component having the diode inside.

11. The solar cell module according to claim 10, wherein the solar cell module further comprises an adapter, the first busbar portion being connected to one of the junction components through the adapter, and the second busbar portion being connected to the diode and the other junction component through the adapter.

12. The solar cell module according to any one of claims 1 to 11, wherein the solar cell module further comprises a substrate, the cell body being disposed on the substrate, and the extending portion being located at a part of the substrate extending beyond the cell body in the second direction.

13. A photovoltaic device, comprising the solar cell module according to any one of claims 1 to 12.

14. A power consuming apparatus, comprising the solar cell module according to any one of claims 1 to 12.

15. A power generation apparatus, comprising the solar cell module according to any one of claims 1 to 12.
